## Europäisches Patentamt

## European Patent Office

## Office européen des brevets

(19)

(11) **EP 0 993 604 B1**

(12) **EUROPÄISCHE PATENTSCHRIFT**

(45) Veröffentlichungstag und Bekanntmachung des Hinweises auf die Patenterteilung:
**23.10.2002 Patentblatt 2002/43**

(51) Int Cl.$^7$: **G01N 23/04**, H01J 37/256

(21) Anmeldenummer: **98942494.0**

(22) Anmeldetag: **06.07.1998**

(86) Internationale Anmeldenummer:
**PCT/DE98/01865**

(87) Internationale Veröffentlichungsnummer:
**WO 99/001753 (14.01.1999 Gazette 1999/02)**

(54) **VERFAHREN ZUR DETEKTION EINES ELEMENTES IN EINER PROBE**

METHOD FOR DETECTING AN ELEMENT IN A SAMPLE

PROCEDE DE DETECTION D'UN ELEMENT DANS UN ECHANTILLON

(84) Benannte Vertragsstaaten:
**BE DE DK ES FR GB IT PT SE**

(30) Priorität: **04.07.1997 DE 19728698**
**16.03.1998 DE 19811395**

(43) Veröffentlichungstag der Anmeldung:
**19.04.2000 Patentblatt 2000/16**

(73) Patentinhaber: **Deutsches Krebsforschungszentrum Stiftung des öffentlichen Rechts 69120 Heidelberg (DE)**

(72) Erfinder:
• **HAKING, Ansgar D-69214 Eppelheim (DE)**
• **RICHTER, Karsten D-68995 Ketsch (DE)**

(74) Vertreter: **Castell, Klaus, Dr. Gutenbergstrasse 12 52349 Düren (DE)**

(56) Entgegenhaltungen:
**US-A- 5 578 823**

• **H. TENAILLEAU ET AL.: "A new background substraction for low-energy EELS core edges." THE JOURNAL OF MICROSCOPY, Bd. 166, Nr. 3, Juni 1992, Seiten 297-306, XP002088762 london**
• **ANONYMOUS: "Spectroscopy Signal Processing Technique" IBM TECHNICAL DISCLOSURE BULLETIN, Bd. 28, Nr. 7, Dezember 1985, Seiten 2903-2904, XP002088763 New York, US**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Detektion eines Elementes in einer Probe, bei dem mit einem Transmissionselektronenmikroskop ein erstes Bild der Intensitäten der Probe in einem Energieverlustbereich vor der Elementkante und ein zweites Bild der Intensitäten der Probe bei einem Energieverlust im Bereich der Elementkante gemessen wird.

Dieses Verfahren wird auch als 2-Fenster-Differenzmethode bezeichnet. Die Schwierigkeit bei dieser Methode liegt darin, daß die Intensität des Untergrundes eine Funktion des Energieverlustes ist und somit innerhalb des Energiefensters verschiedene Untergrundintensitäten festzustellen sind. Die Untergrundintensität hängt im wesentlichen von der Dicke der Probenstelle ab und nimmt zu höherem Energieverlust hin ab. Um das reine elementspezifische Signal, d.h. die elementspezifische Intensität zu ermitteln, wird zunächst in dem für das zu detektierende Element spezifischen Energieverlustbereich die Intensität gemessen und von diesen gemessenen Werten ein Untergrundwert im Energieverlustbereich subtrahiert, wobei der Untergrund im elementspezifischen Energiefenster eine Funktion des Untergrunds außerhalb des elementspezifischen Energiefensters ist. Bei der bekannten Methode wird davon ausgegangen, daß die Intensität des Untergrunds im Bereich des Energiefensters eine lineare Funktion der Intensität vor dem Energiefenster ist.

Für viele Anwendungen ist die Annahme näherungsweise gerechtfertigt. Es ist jedoch einerseits im Stand der Technik nicht befriedigend beschrieben, wie die Parameter der linearen Funktion zu berechnen sind, und andererseits ist davon auszugeben, daß in vielen Fällen eine lineare Funktion den natürlichen Gegebenheiten nicht entspricht.

Aus dem Aufsatz "A new background substraction for low-energy EELS core edges" von H. Tenailleau et al. in Journal of Microscopy, Bd. 166, Nr. 3, Juni 1992, Seiten 297 bis 306 ist ein Verfahren bekannt, bei welchem ein erstes Bild der Intensitäten einer Probe vor der Elementkante und ein zweites Bild der Intensitäten der Probe im Bereich der Elementkante gemessen wird. Die elementspezifische Intensität wird als Differenz der gemessenen Intensität des zweiten Bildes und einer Untergrundintensität berechnet. Hierbei kann die Untergrundintensität als eine exponentielle Gleichung analysiert werden.

Der Erfindung liegt daher die Aufgabe zugrunde, ein gattungsgemäßes Verfahren so weiterzuentwickeln, daß die beschriebene Funktion reproduzierbar bestimmbar ist, um ein genaueres Bild der elementspezifischen Intensitäten zu berechnen.

Diese Aufgabe wird dadurch gelöst, daß an einer Vergleichsprobe die das Element nicht enthält, für verschiedene Punkte die elementunspezifischen Intensitäten $I_1$ bei einem Energieverlust vor der Elementkante ermittelt werden, die elementunspezifischen Intensitäten $I_2$ bei einem Energieverlust im Bereich der Elementkante ermittelt werden, aus diesen Werten eine Näherungsfunktion $I_2 (I_1)$ berechnet wird und ein Bild der elementspezifischen Intensitäten $I_E$ berechnet wird, indem für jeden Punkt des ersten Bildes mit der Intensität $I_{1p}$ mit der Näherungsfunktion die entsprechende Intensität $I_{2p}$ berechnet wird und für den entsprechenden Punkt des zweiten Bildes die Differenz aus gemessener Intensität $I_{2'p}$ und berechneter Intensität $I_{2p}$ als elementspezifische Intensität $I_E$ ermittelt wird.

Das erfindungsgemäße Verfahren erlaubt es, experimentell die Funktion $I_2 (I_1)$ zu bestimmen und mittels dieser experimentell bestimmten Funktion das gemessene Bild der Intensitäten bei einem Energieverlust im Bereich der Elementkante vom elementunspezifischen Untergrund zu bereinigen. Dadurch wird der systematische Fehler deutlich verringert und der Untergrundabzug kann für jede Probe und für alle variablen Parameter, die am Mikroskop eingestellt werden können, angepaßt werden.

Die Intensitätspaare $I_1$ / $I_2$ können graphisch dargestellt werden, so daß auch optisch leicht zu erkennen ist, ob die berechnete Näherungsfunktion den gemessenen Werten entspricht.

Vorteilhaft ist es, wenn die Vergleichsprobe einen Verlauf mit unterschiedlichen Probedicken aufweist. Da die Probendicke am stärksten das Untergrundsignal beeinflußt, ermöglicht ein Verlauf mit unterschiedlichen Probedicken die Messung verschiedener Untergrundsignale und somit die Ermittlung verschiedener Intensitätspaare $I_1$ / $I_2$.

Dieser Verlauf sollte möglichst keine Stufen aufweisen und hat vorzugsweise die Form einer Rampe.

Vorzugsweise weist die Vergleichsprobe mindestens die Dicke der Probe auf. Dadurch wird sichergestellt, daß für alle im Bereich der Probe auftretenden Untergrundsignale ein entsprechendes Untergrundsignal an der Vergleichsprobe zu ermitteln ist.

Bewährt haben sich Vergleichsproben, die aus reinem Kohlenstoff bestehen. Derartige Vergleichsproben lassen sich in allen elektronenmikroskopisch orientierten Labors ohne Probleme herstellen und eignen sich vorallem für biologische Proben, sofern sie nicht nachträglich mit Schwermetallen behandelt wurden.

Es kann darüber hinaus auch eine detailliertere Ermittlung des Untergrundsignals erforderlich sein. Der Grund liegt darin, daß neben einem reinen Massedickekontrast mindestens ein weiterer Kontrastmechanismus bei der Bildentstehung eine Rolle spielt. Dieses kann bspw. eine inhomogene Konzentration verschiedener Elemente sein. Ein hieraus resultierender Kontrast wird als Compositional Contrast (CC) bezeichnet. Aus diesem Grunde kann es vorteilhaft sein, wenn die Vergleichsprobe mindestens zwei Elemente enthält. Wegen des hohen Anteils an Kohlenstoff bei biologischen Proben empfiehlt sich als ein Element Kohlenstoff, während das andere Element möglichst ein schwereres Element als Kohlenstoff, wie bspw. Stickstoff, Sauerstoff oder Schwefel, sein sollte.

Es zeigt sich jedoch, daß die Präparation geeigneter Vergleichsproben nicht ohne weiteres möglich ist. Beispielsweise geht bei einer Vergleichsprobe, die neben Kohlenstoff auch Sauerstoff enthalten soll, beim Aufdampfen fast der gesamte Sauerstoff verloren. Des weiteren scheint ein schwereres Element für eine Vergleichsprobe geeigneter, wobei sich Schwefel nicht bzw. nur sehr schwer in verschiedenen Dicken präparieren läßt.

Aus diesem Grund wurde Dithiouracil (DTU) verwendet. Bei DTU sind die beiden Sauerstoffatome von Uracil, eine der vier Basen der DNA, durch Schwefelatome ersetzt. Denkbar sind jedoch auch Sauerstoff enthaltende Verbindungen.

Um das Rauschen in den von den Bildern abgeleiteten Graphen zu reduzieren, wird vorgeschlagen, daß die Intensität eines jeden Punktes als Mittelwert seiner Umgebung gemessen wird. Bspw. kann jedes der Bilder aus 1014 x 1024 Bildpunkten bestehen, wobei der Intensitätswert jedes Bildpunktes durch den Mittelwert aus der Umgebung von 10 x 10 Bildpunkten ersetzt wird. Nach Erhalt der errechneten Funktion wird jedoch mit den Originalbildern weitergearbeitet.

Um die Güte der Näherungsfunktion zu bestimmen und ggfls. die Näherungsfunktion durch eine weiter angenäherte Funktion zu ersetzen, wird vorgeschlagen, daß die Güte der Funktion $I_2 (I_1)$ durch statistische Funktionen bestimmt wird. Dies ermöglicht es, auch den Fehler des Verfahrens reproduzierbar zu bestimmen.

Das erfindungsgemäße Verfahren wurde mit großem Erfolg am Element Phosphor erprobt. Dieses Verfahren kann aber auch für die Detektion anderer Elemente wie bspw. Eisen angewandt werden. Da DNA Phosphor enthält, erlaubt das erfindungsgemäße Verfahren den Verlauf der DNA z. B. in Viren oder anderen DNA-Protein-Komplexen nachzuweisen.

Verbleibt nach Durchführen des erfindungsgemäßen Verfahrens ein Restkontrast, so kann zumindest ein drittes Bild der Intensitäten $I_{3'p}$ der Probe bei einem dritten Energieverlust aufgenommen werden. Dieser Energieverlust sollte ebenfalls vor der Elementkante liegen und sich von dem Energieverlust des ersten Bildes unterscheiden. An der Vergleichsprobenstelle werden dann für die verschiedenen Punkte dritte Intensitäten $I_{3p}$ bei dem dritten Energieverlust ermittelt. Aus den ermittelten ersten und dritten Intensitäten $I_1$, $I_3$ wird dann die Nährungsfunktion $I_2 (I_1, I_3)$ berechnet. Das Bild der elementspezifischen Intensitäten $I_E$ wird berechnet, indem für jeden Punkt des ersten und dritten Bildes mit der Nährungsfunktion $I_2$ die entsprechende Intensität $I_{2p}$ berechnet wird und für den entsprechenden Punkt des zweiten Bildes die Differenz aus gemessener Intensität $I_{2'p}$ und berechnete Intensität $I_{2p}$ als elementspezifische Intensität $I_E$ ermittelt wird.

Durch eine derartige Verfahrensführung wird es möglich, zwei Kontrastmechanismen zu erfassen. Damit ein derartiges Erfassen ohne weiteres möglich ist, sollte die Vergleichsprobe derart hergestellt werden, daß sie neben der zuvor beschriebenen Dickenänderung auch ein Überschneiden der beiden Vergleichsprobenbestandteile, bspw. reiner Kohlenstoff und DTU, aufweist. Diese kann bspw. so geschehen, daß Kohlenstoff und DTU nacheinander aufgedampft werden, wobei zwischen dem Bedampfen eine Maske verschoben wird. Auf diese Weise sind die Rampen der beiden Elemente ebenso versetzt, so daß sämtliche Massedicken und Konzentrationsunterschiede in der Vergleichsprobe zu finden sind.

Allgemein ausgedrückt ergibt sich die Berechnung des Bildes der elementspezifischen Intensität $I_E$ nach folgender Formel

$$I_E = I_{2'p} - I_{2p} = I_{2'p} - \left(a + \sum_{i=1}^{N} b_i I_1^i + \sum_{i=1}^{N} c_i I_3^i\right)$$

wobei der Verwendung von nur zwei Bildern lediglich eine der Summen und bei der Verwendung von mehreren Bildern entsprechend weitere Summen Verwendung finden.

Im folgenden wird das erfindungsgemäße Verfahren anhand eines Ausführungsbeispiels näher beschrieben.

Es zeigt

Figur 1    die Intensität I des Elektronenstrahls über dem Energieverlust E an einer dicken Probenstelle,

Figur 2    die Intensität I über dem Energieverlust E an einer dünnen Probenstelle,

Figur 3    einen Querschnitt durch ein Präparat mit einer Probe und einer Vergleichsprobe

Figur 4    eine graphische Darstellung der Intensität $I_2$ bei einem Energieverlust im Bereich der Elementkante über der Intensität I, bei einem Energieverlust vor der Elementkante für verschiedene Punkte der Vergleichsprobe,

Figur 5 Aufnahmen von Bildern, eines bei $E_1$ = 115 eV, also vor der Phosphorkante und eines bei $E_2$=160 eV, beim Maximum der Phosphorkante (Abb. 5a/b). Jedes der Bilder besteht aus 1024x1024 Bildpunkten

Figur 6 eine schematische Darstellung einer zwei Elemente umfassenden Vergleichsprobe, und

Figur 7 Bilder bei 50, 80, 115 und 150 eV (Figuren 7a bis 7d) einen Negativtest (Figur 7e) und ein Bild der elementspezifischen Intensitäten (Figur 7f).

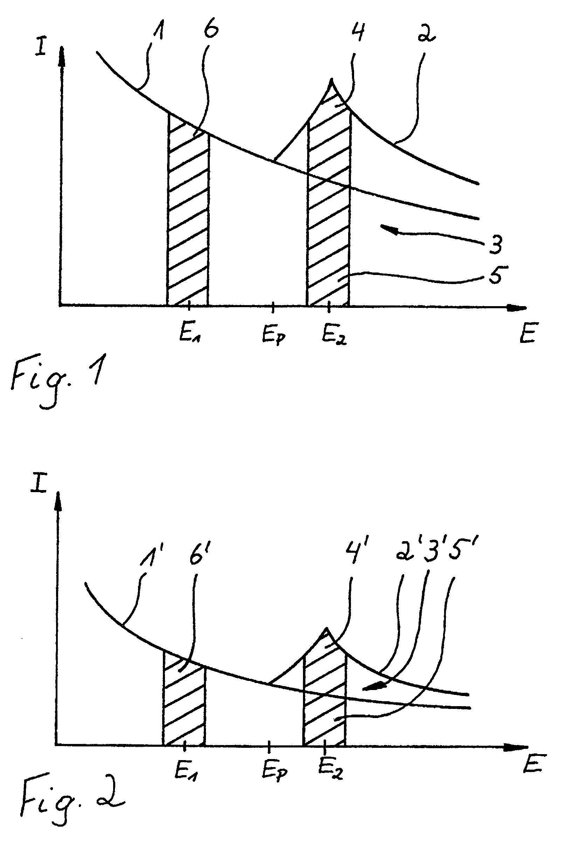

Für jedes Element des Periodensystems gibt es charakteristische Energieverlustbereiche, in denen die Intensität des Elektronenstrahls erhöht ist, wenn dieses Element in der Probe vorhanden ist. Die Figuren 1 und 2 zeigen die Intensität des Elektronenstrahls in Abhängigkeit vom Energieverlust modellhaft für zwei verschieden dicke Probenstellen, in denen sich das gesuchte Zielelement befindet. In diesem Fall ist das Zielelement Phosphor. In beiden Figuren lassen sich zwei verschiedene Signalarten unterscheiden: ein elementunspezifischer Untergrund 1 bzw. 1', der zu höherem Energieverlust hin abnimmt und ein elementspezifisches Signal 2 bzw. 2', das ab einer für das Element typischen Energie auftritt. Für Phosphor tritt dieses Signal am $E_p$ = 130 eV auf und erreicht das Maximum bei $E_2$ = 160 eV. Wegen der Form des elementspezifischen Signals wird auch von einer "Elementkante" gesprochen. Die Lage dieser Elementkante ist für jedes Element spezifisch.

Im vorliegenden Fall soll Phosphor nachgewiesen werden und daher werden die Elektronen herausgefiltert, die 160 eV ($E_2$) verloren haben. Der Bereich um 160 eV unterhalb des elementspezifischen Signals 2 beschreibt eine Fläche 3, die der Intensität $I_{2'p}$ der Probe bei einem Energieverlust im Bereich der Elementkante entspricht. Dieser Intensitätsbereich 3 bzw. 3' besteht aus dem Anteil 4 bzw. 4' des reinen Elementsignals und dem Anteil 5 bzw. 5' des Untergrunds. Um das reine Elementsignal 4 bzw. 4' zu erhalten, muß dieser Untergrund 5 bzw. 5' herausgerechnet werden. Im Stand der Technik wird dieser Untergrund aus Bildern vor der Kante unter Verwendung eines vorbestimmten Rechenalgorithmus berechnet. Diese Algorithmen heißen beispielsweise "power-law, exponential-law, two-windows-differential-law". Das vorliegende Verfahren basiert auf der 2-Fenster-Differenzmethode und zur Berechnung des Untergrundes wird zunächst für einen Energieverlust $E_1$ = 115 eV vor der Kante der Intensitätbereich 6 gemessen. Da das Verhältnis zwischen dem Intensitätsbereich 5 auf der Kante und dem Intensitätsbereich 6 vor der Kante vorallem von der Schichtdicke der Probenstelle abhängt, aber auch von den gewählten Energieverlustbereichen, wird zunächst eine Vergleichsstruktur untersucht, um für bestimmte Energieverluste $E_1$ vor der Kante und $E_2$ auf der Kante die Funktion zwischen der Intensität auf der Kante und der Intensität vor der Kante zu ermitteln.

Als Vergleichsstruktur oder Vergleichsprobe dient ein Präparat oder ein Teil der zu untersuchenden Probe, bei dem das zu detektierende Element mit Sicherheit nicht enthalten ist. Die Vergleichsprobe kann somit ein Teil der zu untersuchenden Präparate sein, in dem das zu untersuchende Element nicht vorhanden ist. Vorzugsweise wird jedoch auf dem Objektträger neben der zu untersuchenden Probe als Extrapräparat eine Vergleichsstruktur erzeugt, von der bekannt ist, daß diese die gleichen Eigenschaften bezüglich des Untergrundsignals hat, wie die zu untersuchende Probe. Die Vergleichsstruktur enthält das gesuchte Element nicht.

Für die Untersuchung von Makromolekülen wird das zu untersuchende Material auf eine Kohlenstofffolie aufgebracht, welche auf einem Kupfernetz liegt. Dieses Verfahren ist allgemein etabliert und wurde so modifiziert, daß auf die Trägerfolie zusätzlich mindestens eine Kohlenstofframpe aufgedampft wird. Diese Rampe wird auch als Massendickemarker bezeichnet, da sie verschiedene Dicken aufweist. Erst dann wurde das zu untersuchende Material aufgebracht.

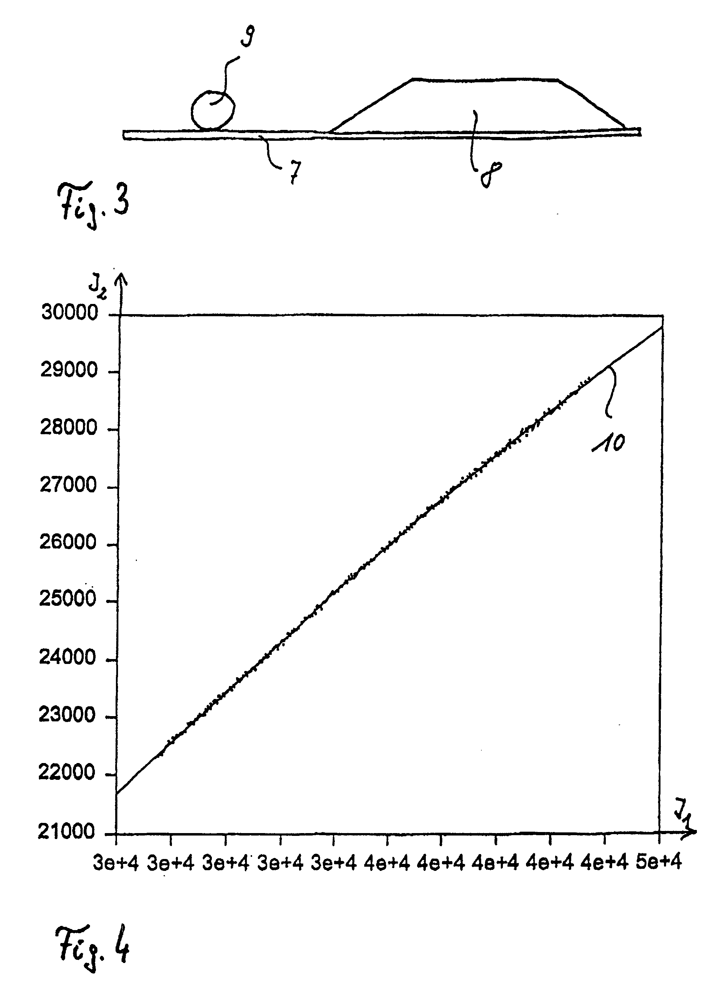

Figur 3 zeigt die Trägerfolie 7 aus Kohlenstoff, auf die als Massendickemarker eine Kohlenstofframpe 8 zusätzlich aufgebracht wurde. Neben der Kohlenstofframpe 8 ist auf die Trägerfolie 7 das zu untersuchende Material 9 aufgebracht. Beim Aufbringen des Massendickemarkers 8 wurde darauf geachtet, daß eine Rampe und keine Stufe entsteht, so daß der Untergrund für alle Dicken zwischen dem Minimum (der Trägerfolie) und dem Maximum des Massendickemarkers ermittelt werden kann. Die maximale Dicke des Markers wurde so gewählt, daß mindestens die Dicke der zu untersuchenden Struktur erreicht wird.

Als Testpräparat wurde im vorliegenden Fall der Turnip Yellow Mosaic Viruses (TYMV) benutzt.

Von dem Testpräparat mit Virus und Kohlenstofframpe wurden Bilder mit 1024 mal 1024 Bildpunkten aufgenommen. Für das erste Bild wurde ein Elektronenstrahl mit einem Energieverlust $E_1$ = 115 eV, also vor der Phosphorkante verwendet und für das zweite Bild wurde ein Elektronenstrahl mit einem Energieverlust $E_2$ = 160 eV beim Maximum der Phosphorkante genutzt.

Um das Rauschen in den von den Bildern abgeleiteten Graphen zu reduzieren, wurde der Intensitätswert jedes Bildpunktes durch den Mittelwert seiner Umgebung, bestehend aus 10 x 10 Bildpunkten ersetzt, wobei danach mit den Originalbildern weitergearbeitet wird. Anschließend wurde ein Bereich ausgewählt, von dem ausgegangen werden kann, daß dieser kein Phosphor enthält. Innerhalb dieses Bereiches wurde für viele Bildpunkte die Intensität vor und auf der Kante gemessen, so daß eine Tabelle aus Wertepaaren $I_1$ (vor der Kante) zu $I_2$ (auf der Kante) entstand. Diese Wertepaare wurden in einem Graphen aufgetragen, in dem die Intensität $I_2$ (auf der Kante) über der Intensität $I_1$ (vor der Kante) für einzelne Bildpunkte dargestellt ist. Bei der Auswahl der Wertepaare wurde darauf geachtet, daß sich die Punkte im Graphen gleichmäßig über den ganzen Intensitätsbereich verteilen, so daß sich eine lückenlose Darstellung ergibt.

Durch die Punkte wurde eine Kurve gefittet. Im vorliegenden Fall hat sich ein Polynom dritter Ordnung als gute Näherungsfunktion 10 ergeben. Die Güte der Näherungsfunktion 10 läßt sich aufgrund statistischer Kriterien überprüfen. Diese Funktion ergibt für den untersuchten Bereich des Massendickenmarkers 8 das Verhältnis von $I_2$ zu $I_1$ für den elementunspezifischen Untergrund.

Vom zuvor erzeugten Bild auf der Kante bei einem Energieverlust $E_2$ von 160 eV wurde nun mit Hilfe der errechneten Funktion und dem Bild vor der Kante der Untergrund subtrahiert, so daß nur das reine Elementsignal übrigblieb. Dabei entstand ein Bild, das nur die elementspezifischen Intensitäten $I_E$ angibt. Hierzu wurde zunächst für jeden Punkt des ersten Bildes mit der Intensität $I_{1p}$ mit der Näherungsfuktion die entsprechende Intensität $I_{2p}$ berechnet und für den entsprechenden Punkt des zweiten Bildes die Differenz aus der gemessenen Intensität $I_{2'p}$ und der berechneten Intensität $I_{2p}$ als elementspezifische Intensität $I_E$ ermittelt.

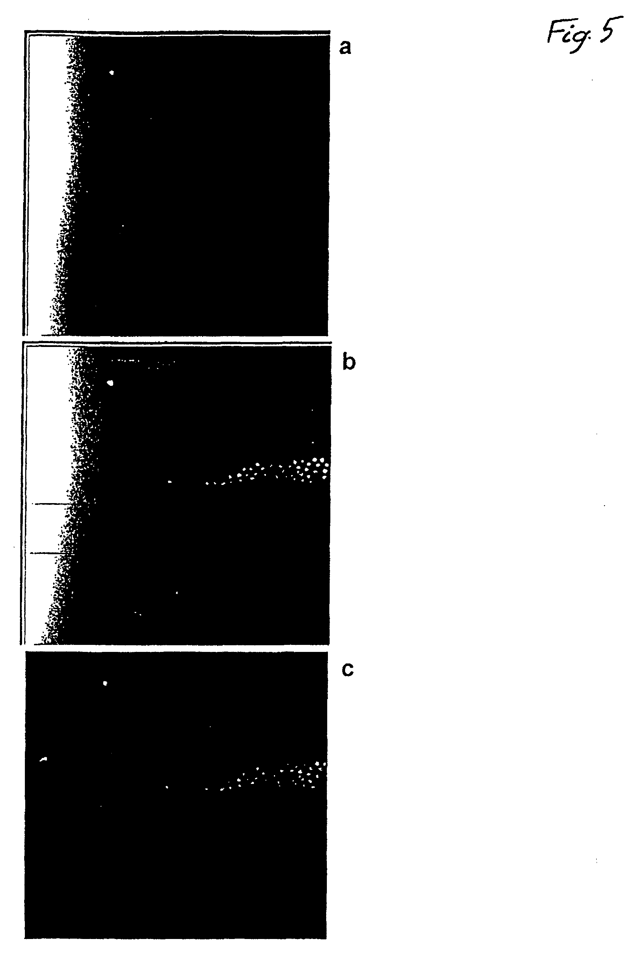

Es zeigt sich, daß bei bestimmten Proben nach Durchführen des Anhand der Figuren 1 bis 5 dargestellten Verfahrens erzeugten Bildes noch ein deutlicher Restkontrast verbleibt. Dieser ist darauf zurückzuführen, daß neben einem reinen Massendickekontrast mindestens ein weiterer Kontratsmechanismus bei der Bildentstehung eine Rolle spielt. Ein solcher Kontrast kann bspw. ein Compositional Contrast (CC) sein, welcher für eine inhomogene Konzentration verschiedener Elemente in einer Probe steht.

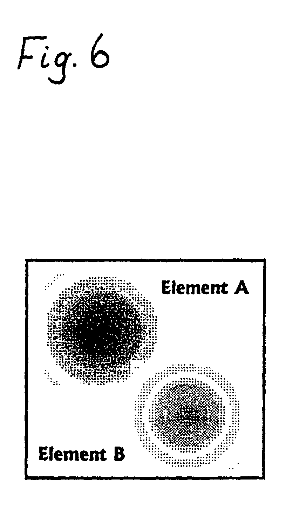

Insofern sollte eine Vergleichsprobe gewählt werden, die zumindest zwei der in den üblichen Proben auftretenden Untergrundelemente enthält. Eine derartige Vergleichsprobe sollte einerseits die zuvor beschriebene Rampen für jedes der enthaltenen Elemente und andererseits auch verschiedene Konzentrationsverhältnisse der beiden Elemente aufweisen. Ein Beispiel für eine derartige Vergleichsprobe ist schematisch in Figur 6 dargestellt. Hierbei ist nicht zwingend, daß die Vergleichsproben elementrein sind.

Vielmehr kann, wie bei dem nachfolgend beschriebenen Ausführungsbeispiel dargestellt, auch eine Verbindung bzw. eine Element- oder Verbindungsmischung Verwendung finden.

Wegen seiner einfachen Darstellbarkeit empfiehlt sich eine Vergleichsprobe, die einerseits reinen Kohlenstoff (als Element A) und andererseits Dithiouracil (DTU) (als Element B) enthält. Hierbei ermöglicht das DTU durch seine Zusammensetzung ($H_4C_4N_2S_2$) ein Einbeziehen von Stickstoff und Schwefel neben Kohlenstoff in die Untergrundberechnung. Andererseits können auch Verbindungen, die Sauerstoff enthalten, wie bspw. Uracil, Verwendung finden.

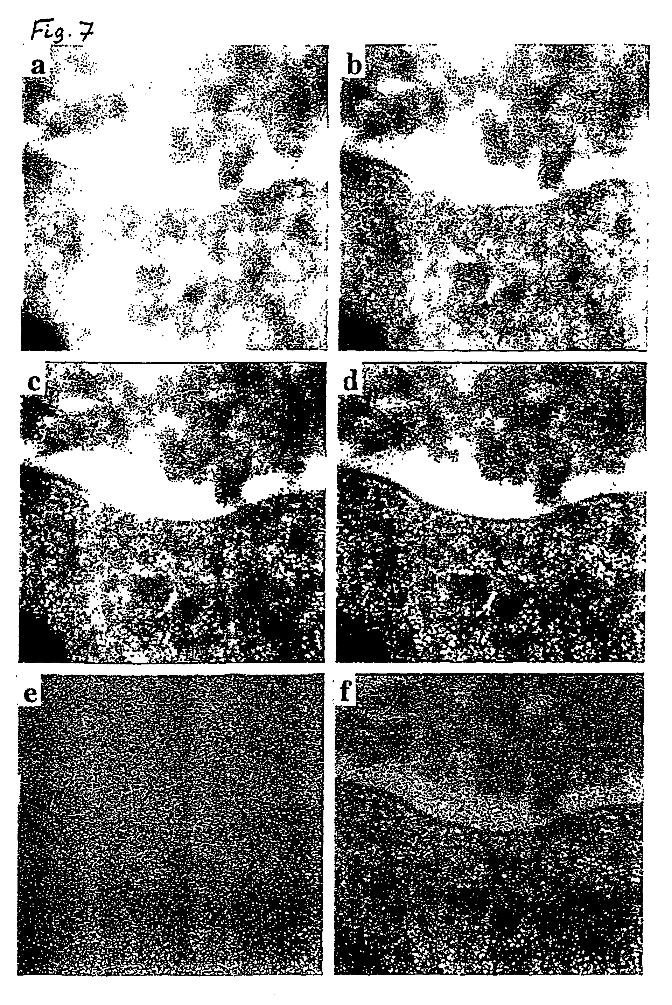

Von einer Vergleichsprobe aus Kohlenstoff und Dithiouracil sowie von einem Schnitt (siehe Figuren 7a bis d) wurden Bilder bei 50, 80, 115, und 150 eV aufgenommen. Mit Hilfe der Vergleichsprobe soll ein Untergrundabzug als Qualitätskontrolle bei 115 eV mittels der Bilder bei 50 und 80 eV durchgeführt werden. Danach wird ein Untergrundabzug für die Phosphordetektion mit Hilfe der Vorkantenbilder bei 80 und 115 eV durchgeführt.

Im Gegensatz zu dem zuvor beschriebenen Ausführungsbeispiel wurde das Bild auf der Phosphorkante bei 150 eV und nicht bei 160 eV aufgenommen. Da die Phosphorkante ein breites Maximum aufweist, bedingt dieses kaum einen Unterschied.

Als Negativergebnis wurde eine Untergrundsfunktion nach der Formel

$$I_{U,115} = a + \sum_{i=1}^{N=2} b_i I_{50}^i + \sum_{i=1}^{N=2} c_i I_{80}^i$$

in Abhängigkeit der Intensitäten bei 50 und 80 eV berechnet. In diese Funktion wurde für jedes Pixel die Intensität der Probenbilder bei 50 und 80 eV eingesetzt und der Untergrund bei 115 eV bestimmt. Das Ergebnis in Figur 7e zeigt außer Rauschen praktisch kein Signal. Hierdurch ist nachgewiesen, daß die Vergleichsprobe den Kontrast in dem Präparat gut beschreibt.

Um den Phosphor in dem Präparat zu detektieren, wurde in gleicher Weise mit Hilfe der Vergleichsprobe die Funktion für den Untergrund bei 150 eV, also auf der Phosphorkante, berechnet. Dieser Untergrund wurde vom Bild der Probe bei 150 eV abgezogen und nach der Formel

$$I_{E,150} = I_{2'p} - \left(a + \sum_{i=1}^{N=2} b_i I_{80}^i + \sum_{i=1}^{N=2} c_i I_{115}^i\right)$$

die Phosporverteilung gemessen (siehe Figur 7f).

Es versteht sich, daß die Vergleichsprobe nicht zwingend separat aufgenommen werden muß. Vielmehr ist es möglich, die Vergleichsprobe entweder auf demselben Träger wie das Präparat zu präparieren bzw. einen Präparatebereich als Vergleichsprobe zu messen, der das gesuchte Element unter Garantie nicht enthält.

## Patentansprüche

1. Verfahren zur Detektion eines Elementes in einer Probe, bei dem mit einem Transmissionselektronenmikroskop ein erstes Bild der Intensitäten $I_{1p}$ der Probe bei einem Energieverlust vor der Elementkante gemessen wird und ein zweites Bild der Intensitäten $I_{2'p}$ bei einem Energieverlust im Bereich der Elementkante gemessen wird, *dadurch gekennzeichnet, daß* an einer Vergleichsprobenstelle, die das Element nicht enthält, für verschiedene Punkte die elementunspezifischen Intensitäten $I_1$ bei einem Energieverlust vor der Elementkante ermittelt werden, die elementunspezifischen Intensitäten $I_2$ bei einem Energieverlust im Bereich der Elementkante ermittelt werden, aus diesen Werten eine Näherungsfunktion (10) berechnet wird und ein Bild der elementspezifischen Intensitäten $I_E$ berechnet wird, indem für jeden Punkt des ersten Bildes mit der Intensität $I_{1p}$ mit der Näherungsfunktion die entsprechende Intensität $I_{2p}$ berechnet wird und für den entsprechenden Punkt des zweiten Bildes die Differenz aus gemessener Intensität $I_{2'p}$ und berechneter Intensität $I_{2p}$ als elementspezifische Intensität $I_E$ ermittelt wird.

2. Verfahren nach Anspruch 1, *dadurch gekennzeichnet, daß* die Vergleichsprobe einen Verlauf mit unterschiedlichen Probedicken aufweist.

3. Verfahren nach Anspruch 2, *dadurch gekennzeichnet, daß* der Verlauf die Form einer Rampe hat.

4. Verfahren nach einem der vorhergehenden Ansprüche, *dadurch gekennzeichnet, daß* die Vergleichsprobe mindestens die Dicke der Probe aufweist.

5. Verfahren nach einem der vorhergehenden Ansprüche, *dadurch gekennzeichnet, daß* die Vergleichsprobe den Hauptbestandteil der Probe enthält.

6. Verfahren nach einem der vorhergehenden Ansprüche, *dadurch gekennzeichnet, daß* die Vergleichsprobe aus reinem Kohlenstoff oder Silizium besteht.

7. Verfahren nach einem der vorhergehenden Ansprüche, *dadurch gekennzeichnet, daß* die Intensität eines jeden Punktes als Mittelwert seiner Umgebung angegeben wird.

8. Verfahren nach einem der vorhergehenden Ansprüche, *dadurch gekennzeichnet, daß* die Güte der Näherungsfunktion $I_2$ durch statistische Funktionen bestimmt wird.

9. Verfahren nach einem der vorhergehenden Ansprüche, *dadurch gekennzeichnet, daß* das detektierte Element Phosphor ist.

10. Verfahren nach einem der vorhergehenden Ansprüche, *dadurch gekennzeichnet, daß* zumindest ein drittes Bild der Intensitäten $I_{3p}$ der Probe bei einem dritten Energieverlust, der vor der Elementkante liegt und sich von dem Energieverlust des ersten Bildes unterscheidet, gemessen wird, und an der Vergleichsprobenstelle für die verschiedenen Punkte dritte Intensitäten $I_3$ bei dem dritten Energieverlust ermittelt werden, die Nährungsfunktion $I_2$ $(I_1, I_3)$ aus den ermittelten ersten und dritten Intensitäten $I_1$, $I_3$ berechnet wird und das Bild der elementspezifischen Intensitäten $I_E$ berechnet wird, indem für jeden Punkt des ersten und dritten Bildes mit der Näherungsfunktion die entsprechende Intentsität $I_{2p}$ berechnet wird und für den entsprechenden Punkt des zweiten Bildes die Differenz aus gemessener Intensität $I_{2'p}$ und berechneter Intensität $I_{2p}$ als elementspezifische Intensität $I_E$ ermittelt wird.

## EP 0 993 604 B1

**Claims**

1. A method for detecting an element in a sample in which a transmission electron microscope is used to measure a first image of intensities $I_{1p}$ of the sample at a distance from the element edge upon energy loss and a second image of intensities $I_{2'p}$ is measured upon energy loss in the region of the element edge, ***characterized in that*** the element non-specific intensities $I_1$ upon energy loss are determined for various points at a distance from the element edge on a reference sample location not containing the element, the element non-specific intensities $I_2$ upon energy loss are determined in the region of the element edge, an approximation function (10) is calculated from these values and an image of the element-specific intensities $I_E$ is calculated by using the approximation function to calculate the corresponding intensity $I_{2p}$ for each point of the first image with intensity $I_{1p}$ and the difference for the corresponding point of the second image is determined as element-specific intensity $I_E$ from measured intensity $I_{2'p}$ and calculated intensity $I_{2p}$.

2. The method according to claim 1, ***characterised in that*** the reference sample has a course with varying sample thicknesses.

3. The method according to claim 2, ***characterized in that*** the course has the form of an incline.

4. The method according to any of the previous claims, ***characterized in that*** the reference sample has at least the thickness of the sample.

5. The method according to any of the previous claims, ***characterized in that*** the reference sample contains the primary component of the sample.

6. The method according to any of the previous claims, ***characterized in that*** the reference sample consists of pure carbon or silicon.

7. The method according to any of the previous claims, ***characterized in that*** the intensity of every point is indicated as the average for its environment.

8. The method according to any of the previous claims, ***characterized in that*** the quality of approximation function $I_2$ is determined using statistical functions.

9. The method according to any of the previous claims, ***characterized in that*** the detected element is phosphorus.

10. The method according to any of the previous claims, ***characterized in that*** at least a third image of intensities $I_{3p}$ is measured upon a third energy loss that is at a distance from the element edge and differs from the energy loss of the first image, and third intensities $I_3$ upon the third energy loss are determined for the various points on the reference sample location, approximation function $I_2$ ($I_1$, $I_3$) is calculated from determined intensities $I_1$, $I_3$ and the image of the element-specific intensities $I_E$ is calculated **in that** the approximation function is used to calculate the corresponding intensity $I_2$ for each point of the first and third images, and the difference for the corresponding point of the second image is determined as element-specific intensity $I_E$ from measured intensity $I_{2'p}$ and calculated intensity $I_{2p}$.

**Revendications**

1. Procédé pour la détection d'un élément dans un échantillon, dans lequel une première image des intensités $I_{1p}$ de l'échantillon est mesurée à l'aide d'un microscope électronique à transmission lors d'une perte d'énergie devant l'arête de l'élément et une deuxième image des intensités $I_{2'p}$ est mesurée lors d'une perte d'énergie dans le secteur de l'arête de l'élément, **caractérisé en ce que**, à un point de l'échantillon comparatif qui ne contient pas l'élément, les intensités $I_1$ non spécifiques à l'élément lors d'une perte d'énergie devant l'arête de l'élément sont calculées pour différents points, les intensités $I_2$ non spécifiques à l'élément lors d'une perte d'énergie devant l'arête de l'élément sont calculées, qu'une fonction d'approche (10) est calculée à partir de ces valeurs et qu'une image des intensités $I_E$ spécifiques à l'élément est calculée en déterminant avec la fonction d'approche pour chaque point de la première image avec l'intensité $I_{1p}$, l'intensité $I_{2p}$ correspondante et pour le point correspondant de la deuxième image, la différence entre l'intensité mesurée $I_{2,p}$ et l'intensité calculée $I_{2p}$ comme intensité $I_E$ spécifique à l'élément.

**2.** Procédé selon la revendication 1, **caractérisé en ce que** l'échantillon comparatif présente une extension avec des épaisseurs différentes.

**3.** Procédé selon la revendication 2, **caractérisé en ce que** l'extension est en forme de rampe.

**4.** Procédé selon une des revendications précédentes, **caractérisé en ce que** l'échantillon comparatif présente au moins l'épaisseur de l'échantillon.

**5.** Procédé selon une des revendications précédentes, **caractérisé en ce que** l'échantillon comparatif contient la composante principale de l'échantillon.

**6.** Procédé selon une des revendications précédentes, **caractérisé en ce que** l'échantillon comparatif consiste en carbone ou silicium pur.

**7.** Procédé selon une des revendications précédentes, **caractérisé en ce que** l'intensité de chaque point est indiquée comme valeur moyenne de son environnement.

**8.** Procédé selon une des revendications précédentes, **caractérisé en ce que** la qualité de la fonction d'approche $I_2$ est définie par des fonctions statistiques.

**9.** Procédé selon une des revendications précédentes, **caractérisé en ce que** l'élément détecté est du phosphore.

**10.** Procédé selon une des revendications précédentes, **caractérisé en ce qu'**au moins une troisième image des intensités $I_{3p}$ de l'échantillon est mesurée lors d'une troisième perte d'énergie qui se situe devant l'arête de l'élément et se différencie de la perte d'énergie de la première image, et qu'au point de l'échantillon comparatif pour les différents points, des troisièmes intensités $I_3$ sont calculées lors de la troisième perte d'énergie, que la fonction d'approche $I_2$ ($I_1$, $I_3$) est calculée à partir des première et troisième intensités calculées $I_1$, $I_3$ et que l'image des intensités $I_E$ spécifiques à l'élément est calculée en calculant pour chaque point de la première et de la troisième image avec la fonction d'approche l'intensité $I_{2p}$ correspondante et en déterminant pour le point correspondant de la deuxième image la différence entre l'intensité mesurée $I_{2,p}$ et l'intensité calculée $I_{2p}$ comme intensité $I_E$ spécifique à l'élément.

Fig. 1

Fig. 2

Fig. 3

Fig. 4

Fig. 5

*Fig. 6*

Fig. 7